(19) Europäisches Patentamt
European Patent Office
Office européen des brevets

(11) **EP 4 080 676 A1**

(12) **EUROPEAN PATENT APPLICATION**
published in accordance with Art. 153(4) EPC

(43) Date of publication:
**26.10.2022 Bulletin 2022/43**

(21) Application number: **20903581.5**

(22) Date of filing: **10.06.2020**

(51) International Patent Classification (IPC):
$H01P\ 1/20$ (2006.01)    $H05K\ 1/02$ (2006.01)
$H01Q\ 15/00$ (2006.01)    $H01Q\ 3/22$ (2006.01)
$H01Q\ 1/28$ (2006.01)    $H01Q\ 21/06$ (2006.01)

(52) Cooperative Patent Classification (CPC):
**H01P 1/20; H01Q 1/28; H01Q 3/22; H01Q 15/00;
H01Q 21/06; H05K 1/02**

(86) International application number:
**PCT/KR2020/007484**

(87) International publication number:
**WO 2021/125466 (24.06.2021 Gazette 2021/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.12.2019 KR 20190168698**

(71) Applicant: **Defense Agency for Technology and
Quality**
**Jinju-si, Gyeongsangnam-do 52851 (KR)**

(72) Inventor: **KIM, Seung Han**
**Jinju-si, Gyeongsangnam-do 52859 (KR)**

(74) Representative: **Eisenführ Speiser
Patentanwälte Rechtsanwälte PartGmbB
Postfach 10 60 78
28060 Bremen (DE)**

(54) **ELECTROMAGNETIC BAND-GAP STRUCTURE**

(57) The present application relates to an electromagnetic band-gap, a directional antenna including same, and a use thereof. The electromagnetic band-gap structure and the directional antenna including same, of the present application, are lightweight and small in size, and can have excellent directivity. In addition, the electromagnetic band-gap structure and the directional antenna including same can be used for aviation electronic equipment and portable measurement equipment.

[FIG. 1]

EP 4 080 676 A1

## Description

[Field of Invention]

The present application relates to an electromagnetic band gap structure, a directional antenna including the same, and a use thereof.

[Background of Invention]

A directional antenna is widely used in a wireless sensor system such as an aircraft using radio and microwave bands. In particular, it is necessary to apply a lightweight and small-sized directional antenna to aviation electronics equipment such as a radar warning system and supporting equipment thereof. In general, a widely used dipole antenna is capable of being used by changing an omnidirectional radiation form to a directional radiation form using a reflector, but in this case, a radiator needs to be spaced apart from the reflector by 1/4 wavelength to secure radiation performance, and thus, there is a difficulty in miniaturization.

The electromagnetic band gap (EBG) structure is realized through a periodic metal pattern and is known to have in-phase reflection characteristics in a band gap frequency band. Due to these characteristics, even if a radiator is located close to an EBG ground plane, there is an advantage that it is possible to secure excellent radiation performance. The EBG structure may be generalized to a special LC network, and may be implemented by arranging the LC network in one or two dimensions. The form configured by applying the two-dimensional EBG structure to the ground plane and applying the antenna to an upper part thereof may greatly improve the directivity of the antenna, but it is difficult to implement the form. On the other hand, the form configured by applying the one-dimensional EBG structure to the ground plane and applying the antenna near the structure is easily implemented, but there is a limit to improving the directivity of the antenna. However, the one-dimensional EBG structure also has another advantage of implementing a lightweight and small antenna. Therefore, there is a demand for a new type of one-dimensional EBG structure that overcomes these limitations.

[Summary of Invention]

[Technical Problem to be Solved]

An object of the present application is to provide an electromagnetic band gap structure and a directional antenna including the same, which are lightweight and compact and achieve excellent directivity. The electromagnetic band gap structure and the directional antenna including the same may be used in aviation electronics equipment and portable measurement equipment.

[Technical Solution]

Therefore, the present application provides an electromagnetic band gap structure including a substrate, a lower layer formed below the substrate and including two or more first slits that are arranged at a predetermined interval on a first surface, and an upper layer formed above the substrate and including two or more second slits that are arranged at a predetermined interval on the first surface, wherein a resonance structure is achieved, and a width or an interval of at least one slit is determined depending on a resonant frequency wavelength of a dipole antenna.

An interval between the two or more first slits may be equal to or less than 0.002 times the resonant frequency wavelength.

The first slit may have a width of 0.015 to 0.020 times the resonant frequency wavelength.

The first slit may have a length of 0.05 to 0.10 times the resonant frequency wavelength.

The first slit may have a thickness equal to or less than 0.0002 times the resonant frequency wavelength.

The lower layer may be formed of one or more metals selected from the group consisting of copper, gold, silver, and aluminum.

The first slit and the second slit may be arranged at equal intervals not to overlap each other.

An interval between the two or more second slits may be equal to or greater than 0.002 times the resonant frequency wavelength.

The second slit may have a width of 0.015 to 0.020 times the resonant frequency wavelength.

The second slit may have a length of 0.05 to 0.10 times the resonant frequency wavelength.

The second slit may have a thickness equal to or less than 0.0002 times the resonant frequency wavelength.

The upper layer may be formed of one or more metals selected from the group consisting of copper, gold, silver and aluminum.

The present application provides a directional antenna including the electromagnetic band gap structure, a dipole antenna including a first dipole device spaced apart from the first surface of the lower layer of the electromagnetic band gap structure, and a second dipole device spaced apart from the first surface of the upper layer of the electromagnetic band gap structure, and a power source configured to apply an electrical signal to the first dipole device and the second dipole device of the dipole antenna.

The first dipole device and the second dipole device may be parallel to the first surface of the electromagnetic band gap structure and may be connected to the power source by a first power line and a second power line, respectively.

Each of the first dipole device and the second dipole device may be spaced apart from the first surface of the electromagnetic band gap structure by an interval equal to or less than 0.06 times the resonant frequency wavelength.

In a state in which the first dipole device and the second dipole device are symmetrical with respect to the first power line and the second power line, a sum of lengths of the first dipole device and the second dipole device may be 0.35 to 0.6 times the resonant frequency wavelength.

The dipole antenna may have a resonant frequency bandwidth equal to or greater than 15%.

The dipole antenna may have a maximum implementation gain equal to or greater than 2 dBi.

The dipole antenna may have radiation efficiency equal to or greater than 80%.

The dipole antenna may have a forward and backward radiation ratio equal to or greater than 8 dB.

Aviation electronics equipment according to the present application may include the directional antenna.

Portable measurement equipment according to the present application may include the directional antenna.

[Effect of Invention]

An electromagnetic band gap structure and a directional antenna including the same according to the present application may be lightweight and compact and may achieve excellent directivity. In addition, the electromagnetic band gap structure and the directional antenna including the same may be used in aviation electronics equipment and portable measurement equipment.

[Brief Description of Drawings]

FIG. 1 is a diagram showing an electromagnetic band gap structure according to an embodiment of the present application.
FIG. 2 is a diagram showing an example of an LC circuit on an electromagnetic band gap structure for explanation of an LC circuit formed by first and second slits of the electromagnetic band gap structure.
FIG. 3 is a diagram showing an LC circuit formed on first and second slits of an electromagnetic band gap structure.
FIG. 4 is a diagram showing a directional antenna according to an embodiment of the present application.

[Best Mode]

Hereinafter, an electromagnetic band gap structure according to the present application will be described with reference to the accompanying drawings, which are illustrative, and the electromagnetic band gap structure according to the present application is not limited to the accompanying drawings.

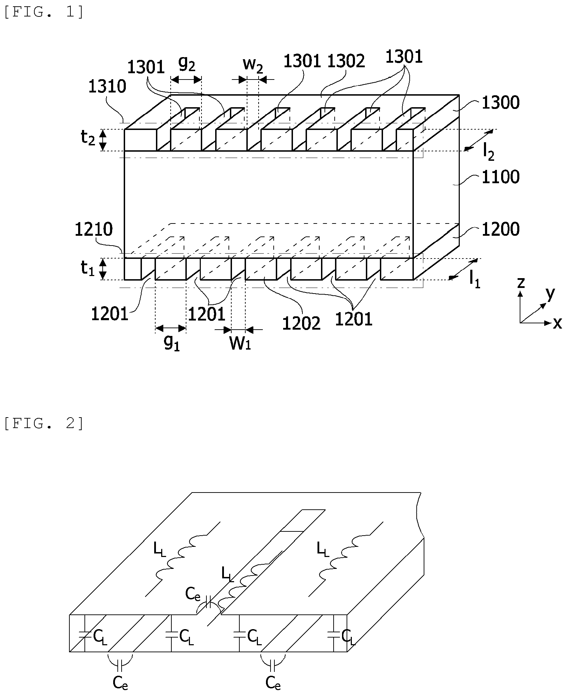

FIG. 1 is a diagram showing an electromagnetic band gap structure according to an embodiment of the present application. As shown in FIG. 1, an electromagnetic band gap structure according to the present application may include a substrate 1100, a lower layer 1200 formed below the substrate, and an upper layer 1300 formed above the substrate. The lower layer 1200 may include two or more first slits 1201 that are arranged at a predetermined interval on a first surface 1210. The upper layer 1300 may include two or more second slits 1301 that are arranged at a predetermined interval on a first surface 1310. The electromagnetic band gap structure according to the present application may have the aforementioned structure, and thus any one or more of a resonant frequency and a bandwidth of the dipole antenna may be excellent, the dipole antenna may be lightweight and compact, and excellent directivity may be achieved by applying the dipole antenna to a dipole antenna to be described later. The interval in the specification may be a length measured in a longitudinal direction of the electromagnetic band gap structure, that is, the x-axis direction. In the specification, the first surface may refer to a side surface formed and pattered by slits. In the specification, the first surface of the lower layer and the first surface of the upper layer may refer to side surfaces at the same side, which are formed on the lower layer and the upper layer, respectively. In the specification, the "slit" means a long and thin hole.

As the substrate, a substrate made of a nonconductive material having the same dielectric constant as that of FR4 may be used. Insulation may be achieved using the aforementioned type of substrate.

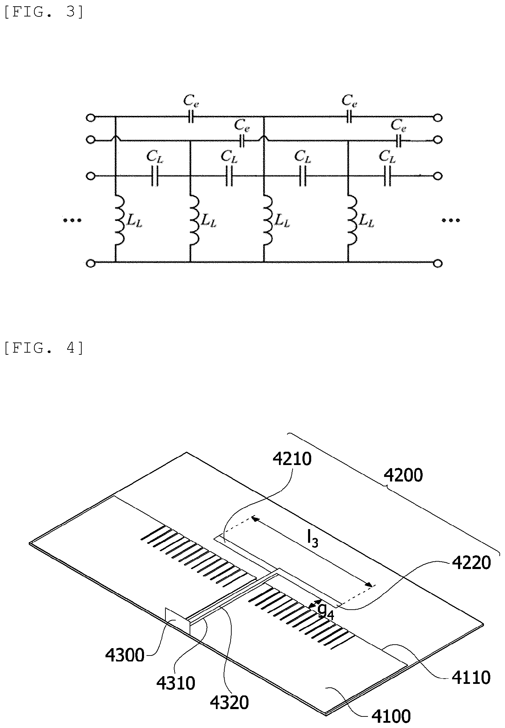

In addition, the electromagnetic band gap structure may have a resonance structure by including the first slit and the second slit. In the specification, the "resonance structure" means a structure configured to transmit a signal wave, a pump wave, and a converted wave and to reflect a secondary harmonic wave to resonate by reciprocating or circulating inside the structure without being transmitted to the outside. FIG. 2 is a diagram showing an example of an LC circuit on an electromagnetic band gap structure for explanation of an LC circuit formed by first and second slits of the electromagnetic band gap structure. FIG. 3 is a diagram showing an LC circuit formed on first and second slits of an electromagnetic band gap structure. As shown in FIGS. 2 and 3, the electromagnetic band gap structure may have the LC circuit formed by the first and second slits, and may have a resonance structure by the LC circuit.

In the electromagnetic band gap structure, the width or the interval of at least one slit may be determined depending on a resonant frequency wavelength of a dipole antenna. In the specification, the resonant frequency refers to a frequency at which current or voltage becomes the maximum by causing a resonance phenomenon when a natural frequency determined by L and C included in the circuit matches a frequency of a power source.

With regard to the resonant frequency, a resonant frequency $f_{sc}$ in series resonance in a series circuit in R, L, and C and a resonant frequency $f_{pc}$ in parallel resonance in a parallel circuit in R, L, and C may be calculated using General Formulae 1 and 2 below, respectively.

[General Formula 1]

$$f_{sc} < \frac{1}{2\pi\sqrt{L_L C_L}}$$

[General Formula 2]

$$f_{pc} < \frac{1}{2\pi\sqrt{L_L C_e}}$$

In General Formulae 1 and 2 above, $L_L$ means inductance formed by each of the lower layer and the upper layer that are formed of conductors of the first and second slits, $C_L$ means capacitance formed between the first slit and the second slit, and $C_e$ means capacitance formed by each of an interval between the first slits and an interval between the second slits.

The resonant frequency $f_{res}$ may be determined as a smaller value among $f_{sc}$ and $f_{pc}$ determined in General formulae 1 and 2 above. In the specification, the "resonant frequency wavelength" means a value obtained by dividing the speed of light by the resonant frequency. For example, when the resonant frequency is 2.5 GHz, the resonant frequency wavelength may be 120 mm. In this case, an interval $g_1$ between the two or more first slits may be equal to or less than 0.0017 times the resonant frequency wavelength.

In an example, the interval $g_1$ between the two or more first slits may be equal to or less than 0.002 times the resonant frequency wavelength, and in detail, may be equal to or less than 0.001. In addition, a lower limit of the interval between the two or more first slits may be equal to or greater than 0.0001 times the resonant frequency wavelength or may be equal to or greater than 0.0005 times the resonant frequency wavelength. The interval between the two or more first slits may refer to an interval between adjacent first slits. The first slit may have an interval having the aforementioned range with an adjacent first slit, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a width $w_1$ of the first slit may be 0.015 to 0.020 times the resonant frequency wavelength, and in detail, may be 0.016 to 0.019 or 0.017 to 0.018 times the resonant frequency wavelength. The first slit may have a width having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a length $l_1$ of the first slit may be 0.05 to 0.10 times the resonant frequency wavelength, and in detail, may be 0.06 to 0.09 or 0.07 to 0.08 times the resonant frequency wavelength. The first slit may have a length having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a thickness $t_1$ of the first slit may be equal to or less than 0.0002 times the resonant frequency wavelength, and in detail, may be equal to or less than 0.0001 times the resonant frequency wavelength. In addition, a lower limit of the thickness of the first slit may be equal to or greater than 0.00001 or may be equal to or greater than 0.00005 times the resonant frequency wavelength. The first slit may have a thickness having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

The lower layer may be a conductor. In detail, the lower layer may be formed of one or more metals selected from the group consisting of copper, gold, silver and aluminum. The lower layer may be formed of the aforementioned type of metal to move electrons.

The lower layer may be formed by printing the aforementioned type of metal above the substrate. The printing scheme may be any scheme known in the art and thus may not be particularly limited.

The first slit and the second slit may be arranged at equal intervals not to overlap each other. In detail, the first slit and the second slit may be disposed not to overlap each other in a height direction. The first slit and the second slit may be arranged at equal intervals not to overlap each other, and thus, when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, an interval $g_2$ between the two or more second slits may be equal to or less than 0.002 times the resonant frequency wavelength, and in detail, may be equal to or less than 0.001 times the resonant frequency wavelength. In addition, a lower limit of the interval between the two or more second slits may be equal to or greater than 0.0001 times the resonant frequency wavelength or may be equal to or greater than 0.0005 times the resonant frequency wavelength. The interval between the two or more second slits may refer to an interval between adjacent second slits. The second slit may have an interval having the aforementioned range with an adjacent second slit, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a width $w_2$ of the second slit may be 0.015 to 0.020 times the resonant frequency wavelength, and in detail, may be 0.016 to 0.019 or 0.017 to 0.018 times the resonant frequency wavelength. The second slit may have a width having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a length $l_2$ of the second slit may be 0.05 to 0.10 times the resonant frequency wavelength, and in detail, may be 0.06 to 0.09 or 0.07 to 0.08 times the resonant frequency wavelength. The second slit may have a length having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

In an example, a thickness $t_2$ of the second slit may be equal to or less than 0.0002 times the resonant frequency wavelength, and in detail, may be equal to or less than 0.0001 times the resonant frequency wavelength. In addition, a lower limit of the thickness of the second slit may be equal to or greater than 0.00001 or may be equal to or greater than 0.00005 times the resonant frequency wavelength. The second slit may have a thickness having the aforementioned range, and thus when the electromagnetic band gap structure according to the present application is applied to a dipole antenna to be described later, a resonant frequency and/or a bandwidth having the following range may be achieved, and accordingly, the electromagnetic band gap structure may be lightweight and compact and may have excellent directivity.

The upper layer may be a conductor. In detail, the upper layer may be formed of one or more metals selected from the group consisting of copper, gold, silver and aluminum. The upper layer may be formed of the aforementioned type of metal to move electrons.

The upper layer may be formed by printing the aforementioned type of metal below the substrate. The printing scheme may be any scheme known in the art and thus may not be particularly limited.

The present application relates to a directional antenna. The directional antenna may include the aforementioned electromagnetic band gap structure, and in this regard, the above description of the electromagnetic band gap structure may be applied to a detailed description of an electromagnetic band gap structure to be described later in the same way, and thus the detailed description of the electromagnetic band gap structure to be described later will be omitted.

FIG. 4 is a diagram showing a directional antenna according to an embodiment of the present application. As shown in FIG. 4, the directional antenna according to the present application may include an electromagnetic band gap structure 4100, a dipole antenna 4200, and a power source 4300. The dipole antenna may include a first dipole device 4210 spaced apart from a first surface of a lower layer of the electromagnetic band gap structure, and a second dipole device 4220 spaced apart from a first surface of an upper layer of the electromagnetic band gap structure. That is, the first dipole device and the second dipole device may be spaced apart from each other. The power source may apply an electrical signal to the first dipole device and the second dipole device of the dipole antenna. The directional antenna according to the present application may have the aforementioned structure, and accordingly may be lightweight and compact and may have excellent directivity. In the specification, "directivity" refers to a phenomenon in which device characteristics show strong properties in a specific direction during transmission and reception of sound, radio waves, and light, that is, properties in which sound, radio waves, and light tend to move in a certain direction. In the specification, the "directional antenna (directional/sectorized antenna)" refers to any antenna except for an isotropic antenna and means an antenna that allows a beam to be formed only in a specific azimuth. In the specification, the "isotropic antenna" means an antenna, radiation intensity of which is constant in any direction. In the specification, the "dipole" means that there are two poles corresponding to each other. In the specification, the "dipole antenna" refers to an antenna that acts like a dipole because power is fed from the center of conductive wires each having an effective antenna length of 1/2 wavelength, and potential distribution and polarity of upper and lower or left and right lines are always symmetrical with respect to the center of the antenna.

The first dipole device and the second dipole device may be parallel to a first surface 4110 of the electromagnetic band gap structure, and may be connected to the power source by a first power line 4310 and a second power line 4320, respectively. The first power line and the second power line may be grounded to a first ground plane 1202 of the lower layer and a first ground plane 1302 of the upper layer, respectively. In addition, each of the first power line and the second power line may be perpendicular to the first surface of the electromagnetic band gap structure.

The dipole antenna having the first dipole device and the second dipole device may be connected to the power source, and thus may receive power.

The first surface of the electromagnetic band gap structure may be any one of side surfaces patterned by the first slit and the second slit of each of the lower layer and the upper layer included in the electromagnetic band gap structure.

Each of the first dipole device and the second dipole device may be spaced apart from the first surface of the electromagnetic band gap structure by an interval $g_4$ that is equal to or less than the resonant frequency wavelength. Each of the first dipole device and the second dipole device may be spaced apart from the first surface of the electromagnetic band gap structure by the aforementioned interval, and thus a resonant frequency and/or a bandwidth having the following range may be achieved, and accordingly, the electromagnetic band gap structure may be lightweight and compact and may have excellent directivity.

In an example, the first dipole device and the second dipole device may be symmetrical with respect to the first power line and the second power line. For example, as long as the first dipole device and the second dipole device are symmetrical with respect to the first power line and the second power line, longitudinal directions of the first dipole device and the second dipole device are not particularly limited. Accordingly, due to this, it is possible to form a dipole antenna that acts like a dipole.

In another example, in the state in which the first dipole device and the second dipole device are symmetrical with respect to the first power line and the second power line, the sum $l_3$ of the lengths of the first dipole device and the second dipole device may be 1/2 of the resonant frequency wavelength. For example, in the state in which the first dipole device and the second dipole device are symmetrical with respect to the first power line and the second power line, the sum $l_3$ of the lengths of the first dipole device and the second dipole device may be 0.35 to 0.6, in detail, 0.4 to 0.55 or 0.45 to 0.5 times the resonant frequency wavelength. The first power line and the second power line overlap each other in the state in which the first dipole device and the second dipole device are symmetrical, and accordingly, in the state in which the first dipole device and the second dipole device are symmetrical with respect to the first power line and the second power line, the sum of the lengths of the first dipole device and the second dipole device may be obtained by excluding the widths of the first power line and the second power line.

The dipole antenna may have a resonant frequency bandwidth equal to or greater than 15%. In detail, the resonant frequency bandwidth of the dipole antenna may be 16% or more, 17% or more, or 18% or more. An upper limit of the resonant frequency bandwidth of the dipole antenna may be 20% or less or 19% or less. The dipole antenna may have a resonant frequency bandwidth having the aforementioned range, and thus may be used for communication and a sensor using various frequencies or a wide frequency. The resonant frequency bandwidth may mean a frequency range that causes resonance. The resonant frequency bandwidth of the dipole antenna may be calculated using General Formula 3 below.

[General Formula 3]

$$\frac{\Delta f}{f_{res}} \propto \sqrt{\frac{L_I}{C_{eff}}}$$

In General Formula 3 above, $f_{res}$ is a resonant frequency, βf is a bandwidth, $C_{eff}$ is capacitance that affects resonance, and $L_L$ is the aforementioned inductance.

The maximum implementation gain of the dipole antenna may be equal to or greater than 2 dBi, in detail, equal to or greater than 3 dBi or equal to or greater than 4 dBi. An upper limit of the maximum implementation gain of the dipole antenna is not particularly limited, but for example, may be 7 dBi or less, 6 dBi or less, or 5 dBi or less. The dipole antenna may have the maximum implementation gain in the aforementioned range, and thus may achieve excellent antenna directivity. The maximum implementation gain may refer to an index for determining the antenna directivity.

The dipole antenna may have radiation efficiency equal to or greater than 80%. In detail, the radiation efficiency of the dipole antenna may be 81% or more, 82% or more, 83% or more, or 84% or more. An upper limit of the radiation efficiency of the dipole antenna may be more advantageous as the upper limit is larger, and for example, the upper limit may be 100% or less, 95% or less, 90% or less, or 85% or less. The electromagnetic band gap structure may include the dipole antenna having the radiation efficiency in the aforementioned range, and thus may be lightweight and compact and may achieve excellent directivity. The radiation efficiency may mean a ratio of power of radio waves radiated from the antenna to power supplied to the antenna.

The dipole antenna may have a forward and backward radiation ratio equal to or greater than 8 dB. In detail, the forward and backward radiation ratio of the dipole antenna may be 8.5 dB or more, 9 dB or more, 9.5 dB or more, 10 dB or more, or 10.5 dB or more. An upper limit of the forward and backward radiation ratio of the dipole antenna may be more advantageous as the upper limit is larger, and for example, the upper limit may be 13 dB or less, 12.5 dB or less, 12 dB or less, 11.5 dB or less, or 11 dB or less. The dipole antenna may satisfy the aforementioned forward and backward radiation ratio, and thus radiation energy may be concentrated in one direction in a directional antenna to maximize the efficiency of the antenna, and radiation in an undesired direction may be prevented. The forward and backward radiation ratio may mean a difference between a radiation gain in a desired direction and a radiation gain in an opposite direction.

The present application relates to use of a directional antenna. An exemplary directional antenna may be lightweight and compact and may achieve excellent directivity.

In an example, the directional antenna may be applied to aviation electronics equipment. An example of the aviation electronics equipment may include a radar warning system or identification friend or foe equipment, and when the directional antenna is included in the radar warning system or the identification friend or foe equipment, the structure is not particularly limited.

In another example, the directional antenna may be applied to portable measurement equipment. An example of the portable measurement equipment may include ground support equipment for verification of a radar warning system, identification friend or foe equipment, or a U/VHF communication device, and when the directional antenna is included in the ground support equipment for verification of a radar warning system, identification friend or foe equipment, or a U/VHF communication device, the structure is not particularly limited.

<Description of reference numerals>

    1100: substrate
    1200: lower layer
    1210: first surface of lower layer
    1201: first slit
    1202: first ground plane of lower layer
    1300: upper layer
    1310: first surface of upper layer
    1301: second slit
    1302: first ground plane of lower layer
    4100: electromagnetic band gap structure
    4110: first surface of electromagnetic band gap structure
    4200: dipole antenna
    4210: first dipole device
    4220: second dipole device
    4300: power source
    4310: first power line
    4320: second power line
    $g_1$: interval between first slits

$w_1$: width of first slit
$l_1$: length of first slit
$t_1$: thickness of first slit
x: longitudinal direction of electromagnetic band gap structure
$g_2$: interval between second slits
$w_2$: width of second slit
$l_2$: length of second slit
$t_2$: thickness of second slit
$g_4$: interval between each of first dipole device and second dipole device and first surface of electromagnetic band gap structure
$l_3$: sum of lengths of first dipole device and second dipole device in state in which first dipole device and second dipole device are symmetrical with respect to first power line and second power line

**Claims**

1. An electromagnetic band gap structure comprising:

   a substrate;
   a lower layer formed below the substrate and including two or more first slits that are arranged at a predetermined interval on a first surface; and
   an upper layer formed above the substrate and including two or more second slits that are arranged at a predetermined interval on the first surface,
   wherein a resonance structure is achieved, and a width or an interval of at least one slit is determined depending on a resonant frequency wavelength of a dipole antenna.

2. The electromagnetic band gap structure according to claim 1, wherein an interval between the two or more first slits is equal to or less than 0.002 times the resonant frequency wavelength.

3. The electromagnetic band gap structure according to claim 1, wherein the first slit has a width of 0.015 to 0.020 times the resonant frequency wavelength.

4. The electromagnetic band gap structure according to claim 1, wherein the first slit has a length of 0.05 to 0.10 times the resonant frequency wavelength.

5. The electromagnetic band gap structure according to claim 1, wherein the first slit has a thickness equal to or less than 0.0002 times the resonant frequency wavelength.

6. The electromagnetic band gap structure according to claim 1, wherein the lower layer is formed of one or more metals selected from the group consisting of copper, gold, silver, and aluminum.

7. The electromagnetic band gap structure according to claim 1, wherein the first slit and the second slit are arranged at equal intervals not to overlap each other.

8. The electromagnetic band gap structure according to claim 1, wherein an interval between the two or more second slits is equal to or greater than 0.002 times the resonant frequency wavelength.

9. The electromagnetic band gap structure according to claim 1, wherein the second slit has a width of 0.015 to 0.020 times the resonant frequency wavelength.

10. The electromagnetic band gap structure according to claim 1, wherein the second slit has a length of 0.05 to 0.10 times the resonant frequency wavelength.

11. The electromagnetic band gap structure according to claim 1, wherein the second slit has a thickness equal to or less than 0.0002 times the resonant frequency wavelength.

12. The electromagnetic band gap structure according to claim 1, wherein the upper layer is formed of one or more metals selected from the group consisting of copper, gold, silver and aluminum.

13. A directional antenna comprising:

the electromagnetic band gap structure of claim 1;
a dipole antenna including a first dipole device spaced apart from the first surface of the lower layer of the electromagnetic band gap structure, and a second dipole device spaced apart from the first surface of the upper layer of the electromagnetic band gap structure; and
a power source configured to apply an electrical signal to the first dipole device and the second dipole device of the dipole antenna.

14. The directional antenna according to claim 13, wherein the first dipole device and the second dipole device are parallel to the first surface of the electromagnetic band gap structure and are connected to the power source by a first power line and a second power line, respectively.

15. The directional antenna according to claim 14, wherein each of the first dipole device and the second dipole device is spaced apart from the first surface of the electromagnetic band gap structure by an interval equal to or less than 0.06 times the resonant frequency wavelength.

16. The directional antenna according to claim 14, wherein, in a state in which the first dipole device and the second dipole device are symmetrical with respect to the first power line and the second power line, a sum of lengths of the first dipole device and the second dipole device is 0.35 to 0.6 times the resonant frequency wavelength.

17. The directional antenna according to claim 13, wherein the dipole antenna has a resonant frequency bandwidth equal to or greater than 15%.

18. The directional antenna according to claim 13, wherein the dipole antenna has a maximum implementation gain equal to or greater than 2 dBi.

19. The directional antenna according to claim 13, wherein the dipole antenna has radiation efficiency equal to or greater than 80%.

20. The directional antenna according to claim 13, wherein the dipole antenna has a forward and backward radiation ratio equal to or greater than 8 dB.

21. Aviation electronics equipment comprising the directional antenna of claim 13.

22. Portable measurement equipment comprising the directional antenna of claim 13.

[FIG. 1]

[FIG. 2]

[FIG. 3]

[FIG. 4]

## INTERNATIONAL SEARCH REPORT

| International application No. |
| --- |
| **PCT/KR2020/007484** |

A. CLASSIFICATION OF SUBJECT MATTER
*H01P 1/20(2006.01)i, H05K 1/02(2006.01)i, H01Q 15/00(2006.01)i, H01Q 3/22(2006.01)i, H01Q 1/28(2006.01)i, H01Q 21/06(2006.01)i*
According to International Patent Classification (IPC) or to both national classification and IPC

B. FIELDS SEARCHED

Minimum documentation searched (classification system followed by classification symbols)
H01P 1/20; G06F 17/50; H01P 1/16; H01Q 1/38; H01Q 13/08; H01Q 15/02; H01Q 19/02; H05K 1/02; H05K 9/00; H01Q 15/00; H01Q 3/22; H01Q 1/28; H01Q 21/06

Documentation searched other than minimum documentation to the extent that such documents are included in the fields searched
Korean utility models and applications for utility models: IPC as above
Japanese utility models and applications for utility models: IPC as above

Electronic data base consulted during the international search (name of data base and, where practicable, search terms used)
eKOMPASS (KIPO internal) & Keywords: slit, electromagnetic bandgap structure, dipole antenna, directional

C. DOCUMENTS CONSIDERED TO BE RELEVANT

| Category* | Citation of document, with indication, where appropriate, of the relevant passages | Relevant to claim No. |
| --- | --- | --- |
| X | US 2015-0130673 A1 (RAYTHEON COMPANY) 14 May 2015 | 1,6-7,12-13,19-22 |
| | See paragraphs [0055]-[0056] and [0067]-[0069]; claims 3-4; and figures 1, 3 and 6A. | |
| Y | | 2-5,8-11,14-18 |
| Y | KR 10-2012-0001994 A (GWANGJU INSTITUTE OF SCIENCE AND TECHNOLOGY) 05 January 2012 | 2-5,8-11,14-18 |
| | See paragraphs [0040]-[0041], [0050], [0057] and [0064]-[0065]; claim 1; and figures 4-5 and 9. | |
| A | US 8816798 B2 (MCKINZIE, William E., III) 26 August 2014 | 1-22 |
| | See column 37, line 38 - column 38, line 51; claim 1; and figures 43-46. | |
| A | US 7982673 B2 (ORTON, Richard Stanley et al.) 19 July 2011 | 1-22 |
| | See column 5, line 30 - column 6, line 37; claim 1; and figures 7 and 10. | |
| A | KR 10-0998720 B1 (SAMSUNG ELECTRO-MECHANICS CO., LTD.) 07 December 2010 | 1-22 |
| | See paragraphs [0068]-[0079]; claim 1; and figure 3. | |

| ☐ Further documents are listed in the continuation of Box C. | ☒ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 26 AUGUST 2020 (26.08.2020) | **28 AUGUST 2020 (28.08.2020)** |

| Name and mailing address of the ISA/KR | Authorized officer |
| --- | --- |
| Korean Intellectual Property Office Government Complex Daejeon Building 4, 189, Cheongsa-ro, Seo-gu, Daejeon, 35208, Republic of Korea Facsimile No. +82-42-481-8578 | Telephone No. |

Form PCT/ISA/210 (second sheet) (January 2015)

# EP 4 080 676 A1

**INTERNATIONAL SEARCH REPORT**
Information on patent family members

| International application No. |
| --- |
| **PCT/KR2020/007484** |

| Patent document cited in search report | Publication date | Patent family member | Publication date |
| --- | --- | --- | --- |
| US 2015-0130673 A1 | 14/05/2015 | US 9323877 B2 | 26/04/2016 |
| KR 10-2012-0001994 A | 05/01/2012 | KR 10-1172812 B1 | 09/08/2012 |
| US 8816798 B2 | 26/08/2014 | US 2009-0051467 A1 | 26/02/2009 |
| | | US 2010-0201465 A1 | 12/08/2010 |
| | | US 2012-0062346 A1 | 15/03/2012 |
| | | US 2015-0171498 A1 | 18/06/2015 |
| | | US 8514036 B2 | 20/08/2013 |
| | | US 9000869 B2 | 07/04/2015 |
| | | US 9362601 B2 | 07/06/2016 |
| | | WO 2009-023753 A2 | 19/02/2009 |
| | | WO 2009-023753 A3 | 09/04/2009 |
| | | WO 2011-106005 A1 | 01/09/2011 |
| US 7982673 B2 | 19/07/2011 | AT 510323 T | 15/06/2011 |
| | | EP 2052438 A1 | 29/04/2009 |
| | | EP 2052438 B1 | 18/05/2011 |
| | | ES 2366019 T3 | 14/10/2011 |
| | | ES 2366019 T8 | 10/11/2011 |
| | | GB 0616391 D0 | 27/09/2006 |
| | | US 2009-0295665 A1 | 03/12/2009 |
| | | WO 2008-020249 A1 | 21/02/2008 |
| KR 10-0998720 B1 | 07/12/2010 | CN 101453828 A | 10/06/2009 |
| | | CN 101453828 B | 16/03/2011 |
| | | DE 102008045055 A1 | 10/06/2009 |
| | | JP 2009-141326 A | 25/06/2009 |
| | | JP 4808755 B2 | 02/11/2011 |
| | | KR 10-2009-0060117 A | 11/06/2009 |
| | | TW 200926911 A | 16/06/2009 |
| | | TW 1374692 B | 11/10/2012 |
| | | US 2009-0145646 A1 | 11/06/2009 |
| | | US 8420949 B2 | 16/04/2013 |

Form PCT/ISA/210 (patent family annex) (January 2015)